Europäisches Patentamt

European Patent Office

Office européen des brevets

(19)

(11) Publication number: **0 342 688**
**A2**

(12) **EUROPEAN PATENT APPLICATION**

(21) Application number: **89109026.8**

(51) Int. Cl.⁴: **H01L 21/00**

(22) Date of filing: **19.05.89**

(30) Priority: **20.05.88 US 196535**

(43) Date of publication of application:
**23.11.89 Bulletin 89/47**

(84) Designated Contracting States:
**DE FR GB IT**

(71) Applicant: **TEGAL CORPORATION**
**2201 South McDowell Boulevard**
**Petaluma California 94953(US)**

(72) Inventor: **Lachenbruch, Roger Bennett**
**495 Sausalito Boulevard**
**Sausalito California 94965(US)**

(74) Representative: **Ibbotson, Harold**
**MOTOROLA European Intellectual Property**
**Operations Jays Close Viables Ind. Estate**
**Basingstoke Hants RG22 4PD(GB)**

(54) **Wafer clamp for plasma reactor.**

(57) A wafer clamp is disclosed in which an annular resilient member (41) is flexed about a region intermediate the inner and outer diameters thereof. The outer edge of the member comprises a thicker, base portion (38) for attachment to the reactor. The inner edge of the clamp comprises a plurality of fingers (37,40) for holding a wafer to be processed.

EP 0 342 688 A2

**FIG. 2**

# WAFER CLAMP FOR PLASMA REACTOR

## Background of the Invention

This invention relates to apparatus for treating semiconductor wafers in a plasma glow discharge and, in particular, to a clamp for holding down a wafer during processing.

Processes for treating articles, such as semiconductor wafers, in a plasma have become more numerous as the benefits of this technique become more widely known. As with any process for manufacturing semiconductors, the temperature of the wafer is important. The wafer temperature not only affects the rate at which reactions take place, but also the characteristics of the wafer itself, e.g. previously formed junctions. In the past, there have been basic approaches to avoiding uncontrolled wafer temperature changes. A first is to heat or cool the wafer by placing it on a thermally conductive member, e.g. a susceptor or an electrode, in a plasma reactor. A second technique is to reduce the power flowing through the wafer. This is accomplished either by reducing the power absolutely or by using remote plasma generation and locating the wafer downstream from the region in which the plasma is generated.

A problem with the first technique, placing the wafer on a thermally conductive member, is the problem of thermal conductivity. The boundary between the wafer and the member is a discontinuity, no matter how flat the wafer and how flat the member. Neither will be perfectly smooth. Thus, the heat can be conducted only at the points of conduct. (Any heat transferred by radiation can be ignored). While in other applications one could wet the wafer and the member with a thermally conductive liquid, such is unavailable in a plasma/vacuum environment.

An improvement has been obtained by clamping the wafer to the member. The pressure increases the contact area and improves thermal conductivity. It is also known to use a wetting of sorts by using a thin layer of thermally conductive gas between the wafer and the member; e.g. U.S. patents 4,615,755, 4,565,601, and 4,261,762, as well as "Experiments on Cooling of Wafers", Nuclear Instruments and Methods, 189 (1981), pages 169-173. By combining gas cooling and wafer clamping, one obtains better thermal conductivity.

A problem with clamping systems of the prior art is their rigidity. Any contact with a wafer is likely to cause some particles to be generated. The firm contact provided by a wafer clamp is a likely source of particles. The situation is worsened if the clamp or wafer is off-center, more likely the wafer since it is being loaded and unloaded.

A related problem is uniformity. Thermal conductivity must be improved, not as a gross measurement, but uniformly across the wafer. For example, increasing thermal conductivity at the edge of the wafer results in a hot spot in the center of the wafer. In terms of functional results, the smoothness of the sidewalls of etched structures is affected by the etch rate, which is affected by temperature, which is affected by thermal conductivity.

At low pressures, e.g. one micron, gas cooling becomes difficult to implement because there is insufficient gas underneath the wafer to provide good thermal conductivity. Raising the pressure of the gas, e.g. helium, dilutes the gases in the reactor and alters the characteristics of the process.

In view of the foregoing, it is therefore an object of the present invention to provide an improved wafer clamp.

Another object of the present invention is to provide a wafer clamp which produces fewer particles than those of the prior.

A further object of the present invention is to provide a wafer clamp for operating at low pressures with gas cooling of the wafer.

Another object of the present invention is to provide a wafer clamp which imposes minimal loss of wafer area from where the clamp overlaps the wafer.

## Summary of the Invention

The foregoing objects are achieved in the present invention wherein an annular shaped, compliant member has an inner diameter slightly smaller than the diameter of the wafer to be clamped. The member has an outer diameter larger than some feature or component of the reactor, which it engages. In a preferred embodiment, the member is held in place by a retaining ring. A plurality of fingers extends inwardly from the outer portion of the member to engage the wafer. The fingers are spaced from each other and extend over other features in the chamber to avoid contact with surfaces which may have accumulated deposits due to previous operations. Thus, the clamp avoids intermittent contact with any other surface, thereby reducing particle generation. The flow of cooling gas is minimized by the clamp design and by dumping excess gas into the vacuum system rather than into the chamber.

## Brief Description of the Drawings

A more complete understanding of the present invention can be obtained by considering the following detailed description in conjunction with the accompanying drawings, in which:

FIG. 1 illustrates a plasma reactor and a gas control system in accordance with the present invention.

FIG. 2 illustrates a wafer clamp in accordance with a preferred embodiment of the present invention.

FIG. 3 illustrates one embodiment of a wafer clamp in accordance with the present invention.

## Detailed Description of the Invention

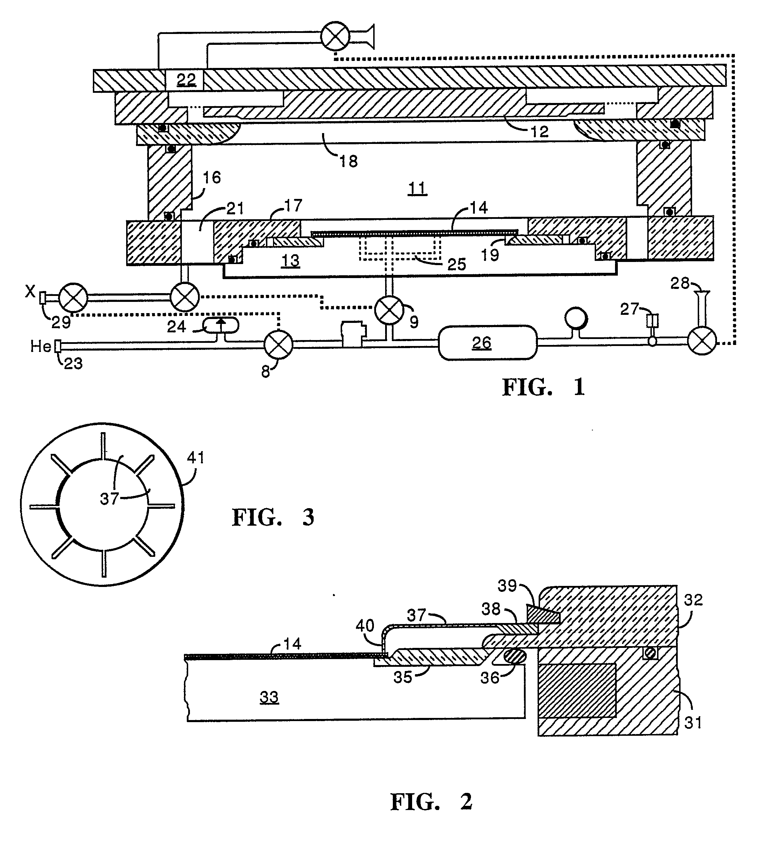

FIG. 1 illustrates a triode, radial flow plasma reactor. Typically, such reactor comprises a chamber 11 for containing the plasma glow discharge formed between upper electrode 12 and moveable lower electrode 13. In addition, sidewall 16, typically comprising aluminum, can be used as a third electrode. These three electrodes are separated by insulators 17 and 18, respectively.

The gas or gas mixture in which the plasma is formed can be supplied through suitable apertures, such as aperture 21 in insulator 17. Gas is exhausted through the large, central aperture in insulator 18, through passageways in upper electrode 12 to exhaust port 22.

Moveable lower electrode 13 comprises a central pedestal 19 for receiving semiconductor wafer 14. The pedestal is surrounded by an insulating ring which engages insulator 17.

. As thus configured, reactor 10 is somewhat limited in the control it provides over the temperature of wafer 14. As previously noted, no matter how smooth wafer 14 or the upper surface of pedestal 19, there will be always exist a boundary layer between electrode 13 and wafer 14. This boundary layer impedes the conduction of heat to or from wafer 14.

FIG. 2 illustrates a preferred embodiment of the present invention which overcomes these problems in providing a clamp for holding wafer 14 to provide more intimate contact between wafer 14 and electrode 33. Specifically, wafer 14 rests on the pedestal of moveable electrode 33 within insulating ring 35. In a preferred a embodiment of the present invention, insulating ring 35 has a taper on the inside edge of the reduced thickness portion thereof for guiding wafer 14 to a central position on electrode 33. As with the reactor of the prior art represented in FIG. 1, a reactor in accordance with the present invention includes insulator 32 resting on lower plate 31. Insulator 32 corresponds to insulator 17 in FIG. 1, differing from insulator 17 in the details of its construction.

The wafer clamp in accordance with the present invention comprises an annular shaped, compliant member having a plurality of fingers extending inwardly to engage the outer edge of the wafer. Specifically, fingers, such as finger 37, extend from a base portion 38 to a curved tip 40 which engages the edge of wafer 14. Base portion 38 is thicker than finger 37 which is cantilever mounted to base portion 38, i.e. finger 37 is mounted at one end thereof which is attached to or part of base portion 38. Retaining ring 39 engages a base portion 38 and fits within a suitable recess within insulator 32.

As thus constructed, the wafer clamp is securely mounted within the chamber yet clears other parts of the chamber to avoid a contact with any other surface except the edge of wafer 14. This is particularly important for reducing the amount of service required on the reactor or, stated another way, increasing the number of cycles the reactor can complete before a cleaning cycle is necessary.

While illustrated in FIG. 2, as parallel to the plain of electrode 33, the fingers, such as finger 37, extend downward slightly when electrode 33 is in a lowered position. As illustrated in FIG. 2, moveable electrode 33 is in its upper most position so that sealing ring 36 engages insulator 32 and moveable electrode 33, thereby sealing the reactor. This slight downward cast of finger 37, and the compliance thereof, determine the force applied to the edge of wafer 14 by curved tip 40.

FIG. 3 illustrates a top view of a preferred embodiment of the present invention wherein wafer clamp 41 comprises an annular shaped member having a plurality of fingers 37 extending inwardly from the outer edge. As described in conjunction with FIG. 2 this outer edge is preferably of greater thickness than the thickness of fingers 37. While illustrated in FIG. 3 as comprising eight, relatively broad fingers which nearly touch, it is understood by those of skill in the art that the number and width of fingers 37 can be varied provided that sufficient force is applied to the edge of wafer 14 and that the force is relatively uniformly distributed about the edge of the wafer so that the wafer is relatively uniformly pressed against electrode 33.

Referring to FIG. 1, a cooling gas, is coupled to the backside of wafer 14 by way of a plurality of passageways 25 through electrode 13. The number and location of passageways 25 is not critical so long as a relatively uniform layer of cooling gas is provided at the gap (not shown) between wafer 14 and electrode 13. In accordance with the present invention, a supply of helium is connected port 23 and conducted through regulator 24, inlet valve 8, a pressure controller, and isolation valve 9 to passageways 25. In addition, ballast chamber 26 is connected to the input side of isolation valve 9. The output of chamber 26 is connected through a manometer to needle valve 27 and a control valve connected to vacuum port 28.

In operation, the inlet and exhaust valves are opened to provide helium and reactive gases to the system. The pressure in the helium line is maintained at approximately 5 torr, while the pressure in reactor 11 is typically maintained at 0.2 torr or less. Chamber 26 serves to dampen out fluctuations in pressure caused by the actuation of valves or the operation of the pressure regulator. Needle valve 27 had previously been adjusted to provide a metered flow into the vacuum line, e.g. 0.5 SCCM, thereby enabling stable operation of the pressure controller.

The majority of gas flow is through needle value 27 to exhaust port 28. A minority of the helium gas flows through passageways 25 into the narrow gap between lower electrode 13 and wafer 14. The gas then leaks out from the sides of wafer 14, but at a minimum rate. Unlike systems of the prior art, this arrangement provides wafer cooling as well as a minimal interference with the process being carried out in reactor 11. Helium, which acts as diluent, is dumped into the vacuum system rather than into reactor 11. In addition, the pressure of the gas underneath wafer 14 can be optimized for enhanced conductivity and need not equal the pressure within reactor 11. The seal obtained with the wafer clamp in accordance with the present invention enables one to maintain a higher pressure drop across wafer 14 with a reduced flow of coolant as compared to systems in the prior art.

The pressure at which the thermal conductivity of the cooling gas degrades depends upon the molecular weight of the gas and the size of the gap between the lower electrode and the backside of the wafer. For example, depending upon surface roughness, argon will start to lose thermal conductivity below 1 torr, approximately, while helium will start to lose thermal conductivity at pressures below 6 torr, approximately. The size of the gap determines the pressure at which thermal conductivity declines, indicating that conductivity depends upon the mean-free-path of the molecules in the gas. In general, lighter gases are better conductors than heavier gas. Hydrogen is undesirable unless it is already a component of the process gases.

The force required to hold down the wafer is proportional to the area of the wafer. For example, a wafer having a diameter of 100 mm., across which is a pressure drop of 6 torr, must be held down with a force greater than 8.9 Newtons (2 pounds). A clamp in accordance with the present invention typically provides a hold-down force of 17.8 Newtons (4 pounds). The lower electrode is preferably domed, e.g. with a radius of 1,000 cm., to match the flexing of the wafer under pressure and to maintain a relatively uniform gap between the wafer and the electrode. The clamp itself can be made from polyimide material, such as "TorLon 4000T" (Amoco) "Vespel SP1" (DuPont) or "Envex 1000" (Rodgers), or anodized aluminum, e.g. 6061 aluminum .075-.090 mm. thick.

There is thus provided by the present invention an improved wafer clamp which enables one to obtain improved thermal coupling between the wafer and the electrode. In addition, the wafer clamp contributes little, if at all, to the generation of particles within the reactor.

Having thus described the invention it will be apparent to those of skill in the art that various modifications can be made within the spirit and scope of the present invention.

## Claims

1. In a plasma reactor having a chamber for containing one or more process gases, an upper electrode (12) and a lower electrode (13) for causing a glow discharge in said gases, and wherein said lower electrode is adapted to receive a semiconductor wafer to be processed, the improvement comprising:
an annular, compliant member (41) having an inner diameter less than the diameter of said wafer and an outer diameter greater than the diameter of said wafer, said member having a plurality of inwardly extending, curved projections (37) for engaging said wafer at the outer edge thereof.

2. The reactor as set forth in claim 1 and further comprising means (32,39) in said chamber for retaining said member.

3. The reactor as set forth in claim 2 wherein said lower electrode is movable between a first position, in which said chamber is opened, and a second position, in which said chamber is closed, and wherein said projections engage said wafer before the chamber is closed.

4. The reactor as set forth in claim 1 wherein said lower electrode (13) comprises at least one (25) aperture for supplying gas to the contact area between said wafer and said lower electrode.

5. The reactor as set forth in claim 4 and further comprising:
a source (23) of gas for conductively cooling said wafer;
means (8,9) for coupling said source to said aperture; and

means (26,27,28) connected to said means for coupling, for diverting some of said cooling gas from said reactor.

6. The reactor as set forth in claim 5 wherein the majority of said cooling gas is diverted from said reactor.

7. The reactor as set forth in claim 6 wherein said means for diverting includes a chamber (26) to ballast the flow of gas through said means for diverting.

**FIG. 1**

**FIG. 3**

**FIG. 2**